## Europäisches Patentamt
## European Patent Office
## Office européen des brevets

(19)

(11) Publication number: **0 169 059**
**B1**

(12)

# EUROPEAN PATENT SPECIFICATION

(45) Date of publication of patent specification: **31.08.88**

(51) Int. Cl.⁴: **H 01 B 1/22**

(21) Application number: **85305081.3**

(22) Date of filing: **17.07.85**

(54) **Flexible, directly solderable conductive compositions, compositions useful in forming them, and their use as coatings on substrates.**

(30) Priority: **18.07.84 US 631973**

(43) Date of publication of application:
**22.01.86 Bulletin 86/04**

(45) Publication of the grant of the patent:
**31.08.88 Bulletin 88/35**

(84) Designated Contracting States:
**AT BE CH DE FR GB IT LI LU NL SE**

(56) References cited:
**EP-A-0 140 585**
**EP-A-0 143 530**

(73) Proprietor: **ELECTRO MATERIALS CORP. OF AMERICA**
**605 Center Avenue**
**Mamaroneck New York 10543 (US)**

(72) Inventor: **Martin, Frank Wayne**
**P O Box 243**
**Baldwin Place New York 10505 (US)**
Inventor: **Shahbazi, Samson**
**68 Highland Avenue**
**Yonkers New York 10705 (US)**

(74) Representative: **Angell, David Whilton**
**ROHM AND HAAS (UK) LTD. European Operations Patent Department Lennig House 2 Mason's Avenue**
**Croydon CR9 3NB (GB)**

The file contains technical information submitted after the application was filed and not included in this specification

Courier Press, Leamington Spa, England.

## Description

This invention is concened with solderable, flexible, conductive compositions, to methods for preparing compositions useful in forming such conductive compositions, and to the coating of substrates with such conductive compositions. More particularly, this invention is concerned with conductive compositions that exhibit good flexibility and solderability and that can be bonded directly to substrates.

An electrically conductive composition applied to a supporting or base structure must be sufficiently conductive to carry electric current and must be firmly adhered or bonded to the support or base. Furthermore, it is desirable that the conductive composition be directly solderable and flexible.

U.S. Patent 3,030,237 discloses an improved coating material essentially comprised of organic resin carrier and a suitable metallic pigment. The invention of this U.S. patent lies in the discovery that a coating having a metallic pigment component consisting of a mixture of ball and flake particles having particular dimensions and used in certain proportions, in combination with an organic resin carrier, can exhibit good adhesion and electrical conductivity. Also disclosed is that conventional wire leads may be silver-soldered to the cured coating known silver soldering techniques.

U.S. Patent 2,959,498 discloses a method of forming conductive silver circuits by first applying, to a resinous dielectric surface, a layer of an incompletely cured thermosetting resin, then applying on said layer, in the outline of the desired conductive circuit, a layer of finely divided silver admixed with a thermoplastic resin containing a solvent for both of said resins, and then heating to cure both layers of applied resins. It is essential that the resinous dielectric surface is firstly coated with a thermosetting resin and that this resin is only partially cured before application of the conductive composition. The conductive circuit is applied over the undercoating of thermosetting resin, preferably by squeezing a silver paste in the desired electrical circuit pattern. The silver paste is composed of finely divided silver particles in a thermoplastic resin in a ratio of silver to resin of between 4:1 and 10:1. The resulting silver circuit pattern is firmly adhered to the resinous substrate and readily accepts solder.

U.S. Patent 4,371,459 discloses flexible, screen-printable, conductor compositions comprising (a) a conductive phase containing silver and base metal powders dispersed in a solution of (b) a multipolymer prepared by copolymerization of vinyl acetate, vinyl chloride, and an ethylenically unsaturated dicarboxylic acid and a linear aromatic polyester resin dissolved in (c) volatile nonhydrocarbon solvent. These compositions are particularly useful for application to membrane touch switches.

EP—A1—0143530 disclose a solderable electrically conductive composition comprising metallic silver particles embedded in a matrix formed from acrylic, carboxylated vinyl and an epoxy. The composition is formed by dissolving acrylic powder and vinyl powder in respective solvents to form a first solution and a second solution. The solutions are then mixed with metallic silver particles and an epoxy to form an ink which is applied to a substrate to form a film thereon. The film is cured to evaporate the solvents and allow polymerization to occur thereby having a solderable electrically conductive film.

Known conductive compositions developed for use in connection with supporting or base structures or other electrical equipment have generally been characterized by unacceptably high electrical resistivity or unacceptably low adhesion to the supporting or base material. Furthermore, many prior art compositions have the disadvantage that they are not directly solderable; that is, time consuming and expensive processes such as electroless plating, are necessary in order to satisfactorily apply solder to the conductive composition. Yet another disadvantage lies in the fact that many of the prior art conductive compositions are not flexible and therefore are unsatisfactory for application to flexible substrates. Additionally, many of the prior art compositions cannot be bonded directly to the substrate onto which they are applied.

While some prior art compositions do avoid some of the above disadvantages, they have the disadvantage that complicated formulations employing additional compounds must be used and additional processing steps must be conducted. Furthermore, prior art compositions do not exhibit all of the characteristics of sufficient conductivity, flexibility and solderability, while at the same time being capable of direct bonding to substrates.

It has for a long time been desired to provide conductive compositions that have good conductivity, adhesion and flexibility and which are directly solderable without having to resort to complicated procedures or formulations. It has also been desired to provide conductive compositions that have sufficient conductivity and flexibility to make them capable of replacing mechanical end connectors on flexible polymer thick film circuits.

The present invention may enable the provision of conductive compositions that adhere directly to a substrate upon which they are applied, are flexible, have good electrical characteristics, and/or are directly solderable, i.e. are solderable without the need to use complicated procedures such as electroless plating.

For example, the present invention may enable the provision of conductive compositions that have sufficient conductivity and flexibility to enable them to replace mechanical end connectors on flexible polymer thick film circuits.

According to one aspect of the present invention there is provided a flexible, directly solderable conductive composition comprising:—

(i) silver, substantially in the form of silver flake, the silver flake being particles in which the average distance across each particle is at least 5 times greater than the average thickness of the particle; and

(ii) resin system comprising:

(a) vinyl chloride/vinyl acetate copolymer having a number average molecular weight of from 14,000 to 35,000, having a weight ratio of vinyl chloride to vinyl acetate of from 80:20 to 90:10, and being free of carboxyl modification;

(b) non water-based epoxy resin that does not crosslink at room temperature; and

(c) epoxy hardener;

the weight ratio of silver to vinyl chloride/vinyl acetate copolymer plus epoxy resin plus epoxy hardener being from 88:12 to 95:5, and the epoxy resin/epoxy hardener being heat curable; with the proviso that the composition does not additionally comprise phenolic resin plus acrylic resin plus polyurethane resin such that the weight ratio of silver to vinyl chloride/vinyl acetate copolymer plus phenolic resin plus acrylic resin plus polyurethane resin plus epoxy resin plus epoxy hardener is from 75:25 to 90:10.

According to a further aspect of the present invention there is provided a method of preparing a composition useful in forming a flexible, directly solderable, conductive composition of the invention, the method comprising mixing together

(a) a first solution comprising the vinyl chloride/vinyl acetate copolymer dissolved in ketone solvent;

(b) a second solution comprising the non water-based epoxy resin and the epoxy hardener dissolved in ester solvent, the epoxy resin/epoxy hardener being heat-curable; and

(c) the silver;

the weight ratio of the silver to vinyl chloride/vinyl acetate copolymer plus epoxy resin plus epoxy hardener being from 88:12 to 95:5, such that the silver is substantially wetted and substantially dispersed in the composition.

The silver, which is preferably exclusively in the form of silver flake, is conveniently distributed throughout the resin system.

The resin system may not only hold the silver in suspension, but may also provide adhesion of the silver to the substrate, hold the silver together such that a conductive path is formed, and provide flexibility. Furthermore, after curing, on a substrate, a coating of a composition comprising the silver and resin system, the region of the coating adjacent to the substrate may be found to have a higher concentration of the resin than the region of the coating adjacent the coating surface, that is, a highly enriched silver layer may occur in the region of the surface of the coating.

The compositions of the present invention are conveniently applied in the liquid state to substrates, that is, the silver and resin system are conveniently mixed with solvent which acts as a vehicle. Once applied to the substrate the compositions can be cured and the solvent evaporated leaving dried, cured compositions that contain only traces, if any, of solvent.

In the following discussion, ratios of certain components employed are disclosed and it is to be noted that unless otherwise indicated, these ratios relate to the compositions in their dried and cured state, not to the compositions in their liquid state during the process of manufacture, that is, not to the compositions containing solvent.

It is important to note that for the purpose of the present invention, the silver employed is substantially in the form of silver flake and is preferably 100% silver flake. Silver in other forms, for example, ball or mixtures of ball and flake, which are not substantially in the form of silver flake, will not lead to the production of compositions demonstrating the advantages of the compositions according to the present invention. For the purposes of the present invention a particle is considered to be in flake form when the distance across, i.e. the average distance across the particle is at least five times greater than the thickness (i.e. the average thickness) of the particle. Preferably, the distance across the particle is at least ten times greater than the thickness of the particle. The presence of only silver substantially in the form of silver flake has a further advantage in that it (i.e. the silver flake) appears to contribute to reducing or eliminating silver migration problems seen in prior art compositions. The average particle size of the silver flake, (i.e. the overall average of the distance across the silver flakes) may be from about 0.5 micrometres to about 50 micrometres, preferably from about 2 micrometers to about 4 micrometres. It is, however, to be understood that, when the average particle size of the silver flake is from 0.5 to 50 micrometers, silver flake particles may be present having a particle size of less than 0.5 micrometres or more than 50 micrometers. If the average particle size of the silver flake is less than 0.5 micrometers, there will be difficulty in getting the compositions to load the silver. If the silver is too fine, the consistency of the composition will be too clay-like. If the average particle size of the silver flake is above about 50 micrometres, then the composition will be difficult to apply. For example, the composition will tend to clog up during processes such as screening. The cured compositions of the invention may, for example, contain from about 88% to 93%, by weight, silver flake.

The vinyl chloride/vinyl acetate copolymers used in the present invention have a number average molecular weight of from about 14,000 to 35,000, preferably about 20,000. Vinyl chloride/vinyl acetate copolymers having molecular weights at the higher end of this molecular weight range have better durability and toughness characteristics than vinyl chloride/vinyl Acetate copolymers having molecular weights at the lower end of the molecular weight range.

We have found that types of vinyl chloride/vinyl acetate polymer, other than the vinyl chloride/vinyl acetate copolymers used in the present invention, are unsatisfactory. We tested a carboxyl modified vinyl chloride/vinyl acetate copolymer having a weight ratio of vinyl chloride to vinyl acetate to maleic acid of 83:16:1. Compositions made with this product were found to deteriorate when solder is applied thereto. Apparently, the presence of the dicarboxylic acid is detrimental to the solderability of the conductive compositions when used in screen printing applications for electronic circuit boards. We have also investigated the use of a polyvinyl buterol, which is a modified polyvinyl alcohol. However, the composition made with this resin was also found to disintegrate when solder was applied to it. The compositions of the present invention require a high performance vinyl chloride/vinyl acetate copolymer; vinyl chloride/vinyl acetate copolymers having a number average molecular weight of less than 14,000 or carboxyl modified vinyl chloride/vinyl acetate copolymers are unsuitable.

The weight ratio of vinyl chloride to vinyl acetate in the vinyl chloride/vinyl acetate copolymers used in the present invention is from about 80:20 to about 90:10, preferably from about 86:16 to about 88:12. A vinyl chloride/vinyl acetate copolymer having a number average molecular weight of 35,000 may have a weight ratio of vinyl chloride to vinyl acetate of about 90:10; and a vinyl chloride/vinyl acetate copolymer having a number average molecular weight of 14,000 may have a weight ratio of vinyl chloride to vinyl acetate of about 86:14.

The epoxy resin employed as part of the resin system can be any type of epoxy resin, e.g. a commercially available epoxy resin, that is non-water based and does not crosslink at room temperature. A suitable epoxy resin is that designated Araldite 6010, sold by Ciba Geigy, this resin being an unmodified liquid epoxy resin of medium viscosity which is based on bisphenol A and epichlorohydrin.

The epoxy hardener employed as part of the resin system may, for example, be the material supplied by the Ciba Geigy and designated HY 940, which is a moderately high viscosity dispersion of a solid polyamide in a liquid epichlorohydrin-bisphenol epoxy resin. The purpose of the epoxy hardener is to crosslink, under curing conditions, with the epoxy resin to form a solid, the epoxy resin and epoxy hardener employed in the present invention must not crosslink at room temperature. The epoxy resin/epoxy hardener is conveniently a heat-curable system, preferably a one step heat-curable system, and should be compatible with the other ingredients such as the solvent. Additionally, the epoxy resin is not a water-based epoxy resin i.e. is organic solvent-based.

The weight ratio of silver to vinyl chloride/vinyl acetate copolymer plus epoxy resin plus epoxy hardener is important. If these components are not used within the ranges of ratios specified, the compositions produced will not possess all of the characteristics hereinbefore described. In the broadest sense the weight ratio of silver to vinyl chloride/vinyl acetate copolymer plus epoxy resin plus epoxy hardener should be from about 88:12 to about 95:5, preferably from about 89:11 to about 91:9.

In the resin system, the weight ratio of vinyl chloride/vinyl acetate copolymer to epoxy resin plus epoxy hardener may, for example, be from about 100:1 to about 2:1, preferably from about 2:1 to about 4:1. The weight ratio of epoxy resin to epoxy hardener may, for example, be from about 30:70 to about 40:60, preferably from about 34:66 to about 38:62.

The conductive compositions of this invention can have from about 88% to about 95% by weight of the silver present in an amount of from about 7% to about 12% by weight of vinyl chloride/vinyl acetate copolymer plus epoxy resin plus epoxy hardener, the percentages being based on the total weight of the silver, vinyl chloride/vinyl acetate copolymer, epoxy resin and epoxy hardener. Furthermore, in the conductive compositions of the present invention, the vinyl chloride/vinyl acetate copolymer may, for example, be present in an amount from about 4% to about 7% by weight, the epoxy hardener may, for example, be present in an amount of from about 0.5% to about 3% by weight, and the epoxy resin may, for example, be present in an amount of from about 0.25% to about 2%, by weight, all percentages being based on the total weight of the silver, vinyl chloride/vinyl acetate copolymer, epoxy resin and epoxy hardener.

As previously stated, the compositions of this invention demonstrate advantages over the prior art compositions. For example, the conductive compositions are flexible and may, therefore, be applied to flexible substrates, for example, membrane key boards. By flexible we mean that the conductive compositions, when applied to substrates, may be subjected to deformative forces without cracking, breaking or releasing from the substrate. The conductive compositions will function satisfactorily both in their deformed state and in their undeformed state. The most severe form of deformation would be to put a crease in the conductive compositions. Even under such severe deformation the compositions are found to exhibit acceptable performance. If the composition cracks or breaks as a result of being distorted, it would not be considered flexible; cracks in the composition cause a severe decrease in conductivity and other electrical and mechanical properties.

Another advantage of the conductive compositions of the present invention is that they are directly solderable. This means that they accept solder directly without the need to use time consuming and expensive procedures such as electroless plating. The conductive compositions can be soldered by any one of a number of methods, for example, by dip or reflow soldering techniques, provided the solder temperature does not exceed 205°C. Of course, the need to use a solder flux is not obviated by the conductive compositions of the present invention. Solder flux is a resin based material that aids the wetability of materials to be soldered (e.g. the conductive compositions of the invention), is non-conductive, is widely used, and is generally a liquid. In the present invention the flux can be applied in a variety of ways. For example, pre-fluxing can be employed wherein the conductive composition to be soldered is first dipped into liquid flux and then the solder is applied while the composition is still wet with flux. Alternatively, the flux can be a component of a solder-alloy mixture, in which case, the vehicle is the flux and pre-fluxing is not required. Additionally, the flux may also be activated or not activated. Activated flux cleans the surface to be soldered.

The compositions of the invention can be applied to a variety of rigid or flexible substrates which may be formed from a variety of materials. For example, the substrates may be ceramic or resinous in nature. Examples of typical substrates are printed circuit boards and membrane key boards. Examples of flexible substrates that can be coated with the compositions of the present invention include polyimide substrates such as that made by E.I. DuPont de Nemour and sold under the trademark Kapton and polyester substrates such as that made by E.I. DuPont de Nemour and sold under the trademark Mylar. The only limitation on the substrate is that it should be able to withstand the soldering conditions without being deformed or destroyed. The compositions of the present invention can be applied to substrates in liquid form and then cured.

Compositions of the invention useful in forming the conductive compositions may be made by dissolving vinyl chloride/vinyl acetate copolymer in ketone solvent to form a first solution, dissolving epoxy resin and epoxy hardener in ester solvent to form a second solution and then mixing the first and second solutions with silver, substantially in the form of silver flake, to form a mixture such that the silver is thoroughly dispersed and wetted. The weight ratio of silver to vinyl chloride/vinyl acetate copolymer to epoxy resin may, for example, be from about 68:4:4 to about 75:6:2. The weight ratio of epoxy resin to epoxy hardener may, for example, be from about 40:60 to about 36:63. The weight ratio of vinyl chloride/vinyl acetate to ketone solvent may, for example, be from about 15:85 to about 25:75, and the weight ratio of epoxy resin plus epoxy hardener to ester solvent may, for example, be from about 100:1 to about 75:25. The weight ratio of the first solution to the second solution may, for example, be from about 100:1 to about 88:12. The vinyl chloride/vinyl acetate copolymer may, for example, be present in an amount of from about 15% to about 25% by weight, based on the weight of the first solution. The epoxy resin and epoxy hardener may, for example, be present in an amount from 70% to about 99% by weight, based on the weight of the second solution, and the silver may, for example, be present in an amount of from about 68% to about 75% by weight, based on the weight of the silver, vinyl chloride/vinyl acetate copolymer, epoxy resin, epoxy hardener ketone solvent and ester solvent.

No special techniques need be used in carrying out the method of this invention other than that the vinyl chloride/vinyl acetate copolymer is dissolved in ketone solvent and the epoxy resin and epoxy hardener are dissolved in ester solvent. The silver may, for example, be added by any conventional technique. The ketone solvent may be any ketone solvent, for example gamma butyrolactone, acetone or cyclohexanone. The ester solvent can be any ester solvent, for example, butyl Carbitol acetate; butyl Carbitol acetate is diethylene glycol monobutyl ether acetate supplied by Union Carbide.

Prior to the application of the composition to the substrate the fineness of grind is conveniently checked to determine if it is 25 micrometers or less. Fineness of grind, may, for example, be checked using any standard technique employing a fineness of grind gauge. If the fineness of grind is not 25 micrometres or less, then the composition is preferably passed through a 3 roll mill until a fineness of grind of 25 micrometres or less is obtained. Using feeler gauges, the roll gaps should be set as follows: 0.051 mm (0.002") gap between apron roll and middle roll and 0.38 mm (0.015") gap between middle roll and back roll. Preferably the composition should not be passed through the 3 roll mill more than three times. Additionally, the viscosity of the composition should preferably range from about 30 to about 100 Pa s (about 30,000 cps to about 100,000 cps) at 25°C when measured using a standard Brookfield viscometer. More preferably, the viscosity is from 30 to 70 Pa s (30,000 cps to 70,000 cps).

The mixture so formed can be applied to a substrate by any one of a number of techniques, for example, by silk screening, spraying or brushing. The mixture can be applied at a thickness of 0.025 mm (1 mil) or more. Once applied to the substrate, the mixture is subsequently dried and cured, for example, at a temperature of from about 100°C to about 170°C for about 15 to about 60 minutes. The drying and curing may, for example, be carried out by any of a number of techniques such as baking in an oven.

The compositions of this invention may be bonded directly to substrates. A method of applying a conductive composition onto a substrate comprises bonding the conductive composition directly to the substrate, the conductive composition comprising silver substantially in the form of flake and a resin system comprising vinyl chloride/vinyl acetate copolymer, epoxy resin and epoxy hardener. The substrate does not need to have been pretreated or precoated with any particular composition or by any process. The compositions according to the invention, after drying and curing, demonstrate good adhesion to the substrate. Typically, the average force required to remove the compositions from a rigid substrate is greater than 3.448 M Pa gauge (500 p.s.i.g.).

A method for measuring the force required to remove (or destroy) a conductive composition according to the present invention from a rigid substrate, involves coating a pad of the conductive composition onto the substrate, the pad being 2.54 mm (one tenth of an inch) square. A 22 gauge tin coated copper wire is then soldered onto the pad perpendicular to the substrate. The force required to tear the pad off of the substrate is then measured by conventional means. Any failure is in the ability of the pad to adhere to the substrate, not in the wire adhering to the pad. Any removal of the conductive composition or deterioration of the composition is considered a failure. One method for measuring the adhesion of a conductive composition according to the present invention on a flexible substrate is standard cross hatch adhesion test which involves printing a circuit design on the substrate. A razor blade is then used to cut a cross hatch pattern in the design. Scotch tape is then applied to the pattern and pressure applied. The scotch tape is then peeled off and observations are made as to whether any of the conductive composition has been removed from the substrate. A composition is classed as either passing or failing the test.

The present invention will now be further illustrated by way of the following examples which are for illustrative purposes only and are not to be construed as imposing any limitation on the scope of the invention.

Although the following Examples all utilize a vinyl chloride/vinyl acetate copolymer designated VYHH, supplied by Union Carbide, other types of vinyl chloride/vinyl acetate copolymer may be employed as long as the copolymer conforms to the specifications hereinbefore described.

Examples
Example I
Method of making a composition according to the invention

A first solution was prepared by dissolving, in gamma butyrolactone, vinyl chloride/vinyl acetate copolymer having a number average molecular weight of 20,000.

A second solution was prepared by dissolving epoxy resin (solid by Ciba Geigy under the trade designation Araldite 6010) and epoxy hardener (sold by Ciba Geigy under the trade designation HY940) in butyl Carbitol acetate.

These two solutions were then mixed together and silver flake having an average particle size of 2 micrometres was added such that the total composition had the following formulation:

  69.52% Silver flake
  22.0% gamma butyrolactone
  5.44% vinyl chloride/vinyl acetate copolymer
  0.66% butyl Carbitol acetate
  0.87% Araldite 6010
  1.49% epoxy hardener—HY940

The resulting mixture was then blended until the silver flake was thoroughly dispersed and wetted.

The composition was then passed through a 3 roll mill that had a 0.051 mm (0.002″) gap between the apron roll and the middle roll and a 0.38 mm (0.015″) gap between the middle roll and the back roll. The composition was passed through the 3 roll mill until a fineness of grain of 23 micrometres was obtained.

The viscosity of the composition was 60 Pa s (60,000 cps).

Example II

The composition of Example I, was applied directly to a rigid substrate by silk screening, and then dried and cured at 125°C for 30 minutes.

Adhesion of the composition to the substrate was 3.448 MPa gauge (500 p.s.i.g.).

Conductivity of the composition was 984.3 milliohms/sq/mm (25 milliohms/sq/mil).

Solderability of the composition was good when solder was applied at 200°C and the solder had the following formulation: 62% tin; 36% lead; 2% silver.

Example III

The composition of Example I was applied directly to a flexible substrate and then dried and cured at 125°C for 30 minutes.

The composition passed the crosshatch adhesion test.

Resistivity was 984.3—1063 milliohms/sq/mm (25—27 milliohms/sq/mil).

Solderability of the composition was good when solder was applied at 200°C and the solder had the following formulation: 62% tin; 36% lead; 2% silver.

"Carbitol", "Kapton", "Mylar" and "Araldite" are trade marks which may be registered in some or all of the designated states.

Attention is directed to our concurrent Application 85 305082.1 (EP—A2—0169060) relating to the subject matter excluded from the present invention by the proviso in Claim 1.

**Claims**

1. A flexible, directly solderable conductive composition comprising:—

(i) silver, substantially in the form of silver flake, the silver flake being particles in which the average distance across each particle is at least 5 times greater than the average thickness of the particle; and

(ii) resin system comprising:

(a) vinyl chloride/vinyl acetate copolymer having a number average molecular weight of from 14,000 to 35,000, having a weight ratio of vinyl chloride to vinyl acetate of from 80:20 to 90:10, and being free of carboxyl modification;

(b) non water-based epoxy resin that does not crosslink at room temperature; and

(c) epoxy hardener;

the weight ratio of silver to vinyl chloride/vinyl acetate copolymer plus epoxy resin plus epoxy hardener being from 88:12 to 95:5, and the epoxy resin/epoxy hardener being heat curable; with the proviso that the composition does not additionally comprise phenolic resin plus acrylic resin plus polyurethane resin such that the weight ratio of silver to vinyl chloride/vinyl acetate copolymer plus phenol resin plus acrylic resin plus polyurethane resin plus epoxy resin plus epoxy hardener is from 75:25 to 90:10.

2. A composition as claimed in claim 1 wherein the silver is present in an amount of from 88% to 95% by weight and the resin system is present in an amount of from 5% to 12%, said percentages being based on the total weight of silver, vinyl chloride/vinyl acetate copolymer, epoxy resin and epoxy hardener.

3. A composition as claimed in claim 1 or claim 2, wherein the weight ratio of (b) to (c) is from 30:70 to 40:60, and/or the weight ratio of (a) to (b) plus (c) is from 100:1 to 2:1.

4. A composition as claimed in claim 1 or claim 2, wherein the vinyl chloride/vinyl acetate copolymer is present in an amount of from 4% to 7% by weight, the epoxy resin is present in an amount of from 0.25% to 2% by weight, and the epoxy hardener is present in an amount of from 0.5% to 3% by weight, the percentages being based on the total weight of silver, vinyl chloride/vinyl acetate copolymer, epoxy resin and epoxy hardener.

5. A composition as claimed in any of claims 1 to 4, wherein the overall average of the distance across the silver flakes is from 0.5 micrometres to 50 micrometres.

6. A composition as claimed in any of claims 1 to 5, wherein the silver is exclusively in the form of silver flake.

7. An article, which comprises a substrate coated with a conductive composition as claimed in any of claims 1 to 6.

8. An article as claimed in claim 7, wherein the substrate is a printed circuit board.

9. A method of soldering a conductive composition as claimed in any of claims 1 to 6 which comprises applying solder, at a temperature of up to 205°C, directly to the conductive composition.

10. A method as claimed in claim 9, wherein the solder is applied by a dip or reflow soldering technique.

11. A method of preparing a composition useful in forming a flexible, directly solderable, conductive composition as claimed in any of claims 1 to 6, the method comprising mixing together

(a) a first solution comprising said vinyl chloride/vinyl acetate copolymer dissolved in ketone solvent;

(b) a second solution comprising said non water-based epoxy resin and said epoxy hardener dissolved in ester solvent;

(c) said silver;

the weight ratio of the silver to vinyl chloride/vinyl acetate copolymer plus epoxy resin plus epoxy hardener being from 88:12 to 95:5.

12. A method as claimed in claim 11, wherein:

(i) the weight ratio of silver to vinyl chloride/vinyl acetate copolymer to epoxy resin is from 68:4:4 to 75:6:2; and/or

(ii) the weight ratio of epoxy resin to epoxy hardener is from 40:60 to 36:63; and/or

(iii) the weight ratio of vinyl chloride/vinyl acetate copolymer to ketone solvent is from 15:85 to 25:75; and/or

(iv) the weight ratio of epoxy resin and epoxy hardener to ester solvent is from about 100:1 to about 75:25; and/or

(v) the weight ratio of the first solution to the second solution is from 100:1 to 88:12.

13. A method as claimed in claim 11, wherein the vinyl chloride/vinyl acetate copolymer is present in an amount of from 15% to 25%, by weight based on the weight of the first solution, the epoxy resin and epoxy hardener are present in an amount of from 70% to 99% by weight based on the weight of the second solution, and the silver is present in an amount of from 68% to 75%, based on the total weight of silver, vinyl chloride/vinyl acetate copolymer, epoxy resin, epoxy hardener, ketone solvent and ester solvent.

14. A method, which comprises applying, to a substrate, a composition prepared by a method as claimed in any of claims 11 to 13, and then drying and curing the composition.

15. A method as claimed in claim 14, wherein the substrate is flexible.

16. A method as claimed in claim 14 or claim 15, wherein the drying and curing of the composition is effected at a temperature of from 100°C to 170°C from 15 to 60 minutes.

**Patentansprüche**

1. Flexible direkt lötbare leitende Masse aus

(i) Silber, im wesentlichen in Form von Silberflocken, wobei die Silberflocken Teilchen sind, in welcher der durchschnittliche Abstand quer zu jedem Teilchen wenigstens 5 mal größer ist als die durchschnittliche Dicke des Teilchens, und

(ii) einem Harzsystem aus

(a) einem Vinylchlorid/Vinylacetat-Copolymeren mit einem Zahlenmittel des Molekulargewichts von 14000 bis 35000 und einem Gewichtsverhältnis von Vinylchlorid zur Vinylacetat von 80:20 bis 90:10, das frei von Carboxyl-modifikation ist,

(b) einem Epoxyharz auf Nichtwasser-Basis, das nicht bei Zimmertemperatur vernetzt, und

(c) einem Epoxyhärter,
wobei das Gewichtsverhältnis von Silber zu Vinylchlorid/Vinylacetat-Copolymerem plus Epoxyharz plus Epoxyhärter 88:12 bis 95:5 beträgt, und die mischung aus Epoxyharz und Epoxyhärter durch Wärme härtbar ist, unter der Voraussetzung, daß die Masse nicht zusätzlich Phenolharz plus Acrylharz plus Polyurethanharz derart enthält, daß das Gewichtsverhältnis von Silber zu Vinylchlorid/Vinylacetat-Copolymerem plus Phenolharz plus Acrlyharz plus Polyurethanharz plus Epoxyharz plus Epoxyhärter von 75:25 bis 90:10 beträgt.

2. Masse nach Anspruch 1, worin das Silber in einer Menge von 88 bis 95 Gew.-% vorliegt und das Harzsystem in einer Menge von 5 bis 12% zugegegen ist, wobei sich die Prozentsätze auf das Gesamtgewicht des Silbers, Vinylchlorid/Vinylacetat-Copolymeren, Epoxyharzes und Epoxyhärters beziehen.

3. Masse nach Anspruch 1 oder 2, worin das Gewichtsverhältnis von (b) zu (c) 30:70 bis 40:60 beträgt und/oder das Gewichtsverhältnis von (a) zu (b) plus (c) 100:1 bis 2:1 ausmacht.

4. Masse nach Anspruch 1 oder 2, worin das Vinylchlorid/Vinylactat-Copolymere in einer Menge von 4 bis 7 Gew.-%, das Epoxyharz in einer Menge von 0,25 bis 2 Gew.-% und der Epoxyhärter in einer Menge von 0,5 bis 3 Gew.-% vorliegt, wobei sich die Prozentangaben auf das Gesamtgewicht an Silber, Vinylchlorid/Vinylacetat-Copolymerem, Epoxyharz und Epoxyhärter beziehen.

5. Masse nach einem der Ansprüche 1 bis 4, worin der Gesamtdurchschnitt des Abstandes quer zu den Silberflocken 0,5 Mikrometer bis 50 Mikrometer beträgt.

6. Masse nach einem der Ansprüche 1 bis 5, worin das Silber ausschließlich in Form von Silberflocken vorliegt.

7. Gegenstand aus einem Substrat, das mit einer leitenden Masse gemäß einem der Ansprüche 1 bis 6 beschichtet ist.

8. Gegenstand nach Anspruch 7, worin das Substrat eine gedruckte Schaltungstafel ist.

9. Verfahren zum Löten einer leitenden Masse gemäß einem der Ansprüche 1 bis 6, welches darin besteht, ein Lötmittel bei einer Temperatur von bis zu 205°C direkt auf die leitende Masse aufzubringen.

10. Verfahren nach Anspruch 9, worin das Lötmittel durch eine Tauch- oder Aufschmelzlötungsmethode aufgebracht wird.

11. Verfahren zur Herstellung einer Masse, die zur Bildung einer flexiblen direkt lötbaren leitenden Masse gemäß einem der Ansprüche 1 bis 6 geeignet ist, wobei das verfahren darin besteht, daß

(a) eine erste Lösung aus einem Vinylchlorid/Vinylacetat/Copolymeren, gelöst in einem Ketonlösungsmittel,

(b) eine zweite Lösung aus dem erwähnten Epoxyharz auf Nichtwasser-Basis und dem erwähnten Epoxyhärter, aufgelöst in einem Esterlösungsmittel, und

(c) das erwähnte Silber vermischt werden, wobei das Gewichtsverhältnis des Silbers zur dem Vinylchlorid/Vinylacetat-Copolymeren plus Epoxyharz plus Epoxyhärter 88:12 bis 95:5 beträgt.

12. Verfahren nach Anspruch 11, worin

(i) das Gewichtsverhältnis von Silber zu Vinylchlorid/Vinylacetat-Copolymerem zu Epoxyharz 68:4:4 bis 76:6:2 beträgt und/oder

(ii) das Gewichtsverhältnis von Epoxyharz zu Epoxyhärter 40:60 bis 36:63 beträgt und/oder

(iii) das Gewichtsverhältnis von Vinylchlorid/Vinylacetat-Copolymerem zu dem Ketonlösungsmittel 15:85 bis 25:75 beträgt und/oder

(iv) das Gewichtsverhältnis von Epoxyharz und Epoxyhärter zu Esterlösungsmittel ungefähr 100:1 bis ungefähr 75:25 beträgt und/oder

(v) das Gewichtsverhältnis der ersten Lösung zur der zweiten Lösung 100:1 bis 88:12 beträgt.

13. Verfahren nach Anspruch 11, worin das Vinylchlorid/Vinylacetat-Copolymere in einer Menge von 15 bis 25 Gew.-%, bezogen auf das Gewicht der ersten Lösung, vorliegt, das Epoxyharz und der Epoxyhärter in einer Menge von 70 bis 99 Gew.-%, bezogen auf das Gewicht der zweiten Lösung, vorliegt und das Silber in einer Menge von 68 bis 75%, bezogen auf das Gesamtgewicht aus Silber, Vinylchlorid/Vinylacetat-Copolymerem, Epoxyharz, Epoxyhärter, Ketonlösungsmittel und Esterlösungsmittel, vorliegt.

14. Verfahren, welches darin besteht, auf einem Substrat eine Masse, hergestellt nach einem Verfahren gemäß einem der Ansprüche 11 bis 13, aufzubringen und dann die Masse zu trocknen und zu härten.

15. Verfahren nach Anspruch 14, worin das Substrat flexibel ist.

16. Verfahren nach Anspruch 14 oder 15, wobei das Trocknen und Härten der Masse bei einer Temperatur von 100 bis 170°C während 15 bis 60 Minuten durchgeführt wird.

**Revendications**

1. Une composition conductrice flexible directement soudable comprenant:

(i) de l'argent, essentiellement sous forme de paillettes d'argent, les paillettes d'argent étant des particules dont la distance moyenne transversalement à chaque particule est au moins cinq fois supérieure à l'épaisseur moyenne de la particule; et

(ii) un système de résines comprenant:

(a) un copolymère de chlorure de vinyle/acétate de vinyl ayant une moyenne numérique du poids moléculaire de 14 000 à 35 000, ayant un rapport pondéral du chlorure de vinyle à l'acétate de vinyle de 80/20 à 90/10 et étant dépourvu de modification carboxylique;

(b) une résine époxyde qui n'est pas à base d'eau et qui ne se réticule pas à la température ambiante; et

(c) un durcisseur époxyde;

le rapport pondéral de l'argent à la somme du copolymère de chlorure de vinyle/acétate de vinyle, de la résine époxyde et du durcisseur époxyde étant de 88/12 à 95/5 et la résine époxyde/durcisseur époxyde étant thermodurcissable; sous réserve que la composition ne contienne pas, de plus, de résine phénolique et de résine de polyuréthane pour que le rapport pondéral de l'argent à la somme du copolymère de chlorure de vinyle/acétate de vinyle, de la résine phénolique, de la résine acrylique, de la résine de polyuréthane, de la résine époxyde et du durcisseur

15 0 169 059 16

époxyde soit de 75/25 à 90/10.

2. Une composition comme revendiqué dans la revendication 1 où l'argent est présent en une quantité de 88% à 95% en poids et le système de résine est présent en une quantité de 5% à 12%, lesdits pourcentages étant exprimés relativement au poids total de l'argent, du copolymère de chlorure de vinyle/acétate de vinyle, de la résine époxyde et du durcisseur époxyde.

3. Une composition comme revendiqué dans la revendication 1 ou la revendication 2 où le rapport pondéral de (b) à (c) est de 30/70 à 40/60 et/ou le rapport pondéral de (a) à (b) plus (c) est de 100/1 à 2/1.

4. Une composition comme revendiqué dans la revendication 1 ou la revendication 2, où le copolymère de chlorure de vinyle/acétate de vinyle est présent en une quantité de 4% à 7% en poids, la résine époxyde est présente en une quantité de 0,25% à 2% en poids, et le durcisseur époxyde est présent en une quantité de 0,5% à 3% en poids, les pourcentages étant exprimés relativement au poids total de l'argent, du copolymère de chlorure de vinyl/acétate de vinyle, de la résine époxyde et du durcisseur époxyde.

5. Une composition comme revendiqué dans l'une quelconque des revendications 1 à 4, où la moyenne globale de la distance transversalement à chaque paillette d'argent est de 0,5 micromètre à 50 micromètres.

6. Une composition comme revendiqué dans l'une quelconque des revendications 1 à 5, où l'argent est exclusivement sous forme de paillettes d'argent.

7. Un article qui comprend un substrat revêtu d'une composition conductrice comme revendiqué dans l'une quelconque des revendications 1 à 6.

8. Un article comme revendiquè dans la revendication 7, où le substrat est une plaque à circuit imprimé.

9. Un procédé de soudage d'une composition conductrice comme revendiqué dans l'une quelconque des revendications 1 à 6, qui comprend l'application de soudure, à une température allant jusqu'à 205°C, directement à la composition conductrice.

10. Un procédé comme revendiqué dans la revendication 9, dans lequel la soudure est appliquée selon une technique de soudage au trempé ou par fusion et resolidification.

11. Un procédé de préparation d'une composition utile pour former une composition conductrice flexible directement soudable comme revendiqué dans l'une quelconque des revendications 1 à 6, le procédé comprenant le mélange mutuel de

(a) une première solution comprenant ledit copolymère de chlorure de vinyl/acétate de vinyle dissous dans un solvant de type cétone;

(b) une seconde solution comprenant ladite résine époxyde qui n'est pas à base d'eau et ledit durcisseur époxyde dissous dans un solvant de type ester;

(c) ledit argent;

le rapport pondéral de l'argent à la somme du copolymère de chlorure de vinyle/acétate de vinyle, de la résine époxyde et du durcisseur époxyde étant de 88/12 à 95/5.

12. Un procédé comme revendiqué dans la revendication 11, où:

(i) le rapport pondéral de l'argent au copolymère de chlorure de vinyle/acétate de vinyle et à la résine époxyde est de 68/4/4 à 75/2/2; et/ou

(ii) le rapport pondéral de la résine époxyde au durcisseur époxyde est de 40/60 à 36/63; et/ou

(iii) le rapport pondéral du copolymère de chlorure de vinyle/acétate de vinyle au solvant de type cétone est de 15/85 à 25/75; et/ou

(iv) le rapport pondéral de la résine époxyde et du durcisseur époxyde au solvant de type ester est d'environ 100/1 à environ 75/25; et/ou

(v) le rapport pondéral de la première solution à la seconde solution est de 100/1 à 88/12.

13. Un procédé comme revendiqué dans la revendication 11, où le copolymère de chlorure de vinyle/acétate de vinyle est présent en une quantité de 15% à 25% en poids par rapport au poids de la première solution, la résine époxyde et le durcisseur époxyde sont présents en une quantité de 70% à 99% en poids par rapport au poids de la seconde solution, et l'argent est présent en une quantité de 68% à 75% relativement au poids total de l'argent, du copolymère de chlorure de vinyle/acétate de vinyle, de la résine époxyde, du durcisseur époxyde, du solvant de type cétone et du solvant de type ester.

14. Un procédé qui comprend l'application à un substrat d'une composition préparée selon un procédé comme revendiqué dans l'une quelconque des revendications 1 à 13, puis le séchage et le durcissement de la composition.

15. Un procédé comme revendiqué dans la revendication 14 où le substrat est flexible.

16. Un procédé comme revendiqué dans la revendication 14 ou la revendication 15 où le séchage et le durcissement de la composition sont effectués à une température de 100°C à 170°C pendant 15 à 60 minutes.